Europäisches Patentamt

European Patent Office

Office européen des brevets

(11) Numéro de publication: **0 229 574 B1**

## FASCICULE DE BREVET EUROPEEN

(45) Date de publication de fascicule du brevet:
13.03.91

(51) Int. Cl.5: **H01L 31/072**

(21) Numéro de dépôt: 86402974.9

(22) Date de dépôt: 31.12.86

(54) Detecteur photovoltaique en HgCdTe a heterojonction et son procédé de fabrication.

(30) Priorité: 08.01.86 FR 8600172

(43) Date de publication de la demande:
22.07.87 Bulletin 87/30

(45) Mention de la délivrance du brevet:
13.03.91 Bulletin 91/11

(84) Etats contractants désignés:
DE GB IT NL

(56) Documents cités:
EP-A- 0 064 918
EP-A- 0 090 669
FR-A- 2 535 899
GB-A- 2 029 639

JOURNAL OF APPLIED PHYSICS, vol. 57, no.
8, Part 1, 15 avril 1985, pages 2671-2694,
American Institute of Physics, Woodbury,
US; M.A. HERMAN et al.:
"Hg1-xCdxTe-Hg1-yCdyTe (0 inférieur ou
égal à x, y inférieur ou égal à 1) heterostructures: Properties, epitaxy, and applications"

PROCEEDING DE LA CONFERENCE EURO-
PEENNE SUR LES COMMUNICATIONS OPTI-
QUES, Cannes, FR, 21-24 Septembre 1982,
pages 389-393; G. PICHARD et al.:
"Photodiodes HgCdTe pour télécommunications par fibres optiques à grande distance",
Communication AXI-6

(73) Titulaire: **COMMISSARIAT A L'ENERGIE ATO-
MIQUE Etablissement de Caractère Scientifique Technique et Industriel
31/33, rue de la Fédération
F-75015 Paris(FR)**

(72) Inventeur: **Amingual, Daniel
2, rue Jean Mace
F-38000 Grenoble(FR)**
Inventeur: **Felix, Pierre
8, Boulevard Roger Salengro
F-38100 Grenoble(FR)**

(74) Mandataire: **Mongrédien, André et al
c/o BREVATOME 25, rue de Ponthieu
F-75008 Paris(FR)**

**Description**

La présente invention a pour objet un détecteur photovoltaïque à structure plane en HgCdTe et son procédé de fabrication. Ce détecteur, dont le matériau semiconducteur HgCdTe présente une faible largeur de bande interdite, est particulièrement bien adapté à la détection du rayonnement infrarouge.

Le composé semi-conducteur est en fait une solution solide de tellurure de mercure (HgTe) et de tellurure de cadmium (CdTe), de formule $Hg_{1-x}Cd_xTe$. Le paramètre x compris entre 0 et 1, appelé communément composition, fixe le rapport tellurure de cadmium sur tellurure de mercure. Il fixe également la largeur de bande interdite Eg du composé. Cette largeur de bande interdite Eg fixe à son tour le domaine spectral de détection du rayonnement : une largeur de bande interdite Eg permet de détecter les photons de longueur d'onde inférieure à la longeur d'onde de coupure $\lambda_c$ du détecteur, avec $\lambda_c = 1,24/Eg$ ($\lambda_c$ est exprimé en $\mu m$ et Eg en eV).

La composition x peut être ajustée continûment, permettant ainsi de couvrir un vaste domaine spectral depuis $\lambda_c = 0,8$ $\mu m$ (x = 1) jusqu'à de très grandes longueurs d'onde (Eg = 0 pour x ≈ 0,17), des détections jusqu'à 30 $\mu m$ de longueur d'onde ayant été démontrées.

On s'intéresse le plus souvent aux gammes spectrales adaptées aux fenêtres de transmission atmosphériques, par exemple les fenêtres de longueur d'onde de 3 à 5 $\mu m$ et 8 à 12 $\mu m$. Ces fenêtres de transmission sont en effet bien adaptées à l'imagerie thermique puisque les objets à température proche de l'ambiante (290° K) ont un maximum d'émission propre vers 10 $\mu m$ de longueur d'onde. Les compositions x voisines de 0,30 et de 0,20 correspondent respectivement aux gammes spectrales de 3 à 5 $\mu m$ et de 8 à 12 $\mu m$.

Le composé HgCdTe a été universellement adopté pour la réalisation des détecteurs équipant actuellement les systèmes infrarouges de haute performance. Ces détecteurs sont soit du type photoconducteur, soit du type photovoltaïque. C'est sur ce second type de dispositifs que porte l'invention.

Le composé en HgCdTe semble aussi le plus prometteur, pour la réalisation de mosaïques de détecteurs à lecture électronique intégrée devant équiper les systèmes infrarouges futurs. Il permet en effet de réaliser des détecteurs photovoltaïques de haute qualité, qui permettent un couplage optimum au circuit de lecture avec une très faible dissipation.

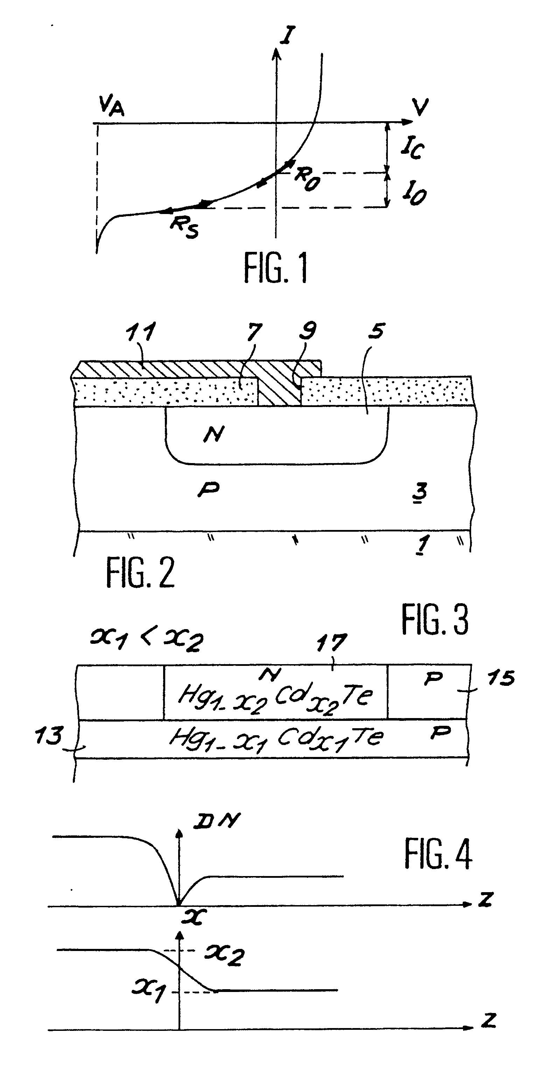

On va rappeler brièvement les différents critères de performances auxquels doit répondre un détecteur photovoltaïque. Les paramètres les plus importants, qui apparaissent sur la figure 1 annexée, représentant la caractéristique I = f(V) d'un tel détecteur, sont :
- un courant de court-circuit ou photocourant $I_c$, fonction du flux de photons incident,
- un courant d'obscurité $I_o$, correspondant à une polarisation inverse du détecteur, qui doit être faible devant le photocourant $I_c$,
- une résistance dynamique $R_o$ à polarisation nulle, qui doit être élevée,
- une résistance shunt $R_s$, correspondant à une résistance dynamique lorsque le détecteur est polarisé en inverse, qui doit être élevée pour un couplage optimum au circuit électronqiue de lecture et pour minimiser le bruit du détecteur polarisé en inverse, et
- une tension d'avalanche $V_A$ élevée.

L'ensemble de ces performances impose naturellement une limite supérieure de la température d'utilisation limite d'autant plus faible que la longueur de bande interdite Eg est faible et donc la longueur d'onde de coupure $\lambda_c$ grande. En particulier $R_o$ varie comme exp(-Eg/kT) ou exp (-Eg/2kT) suivant le domaine de température d'utilisation, k étant la constante de Boltzmann et T la température en ° Kelvin.

A l'opposé, vers les basses températures, les performances plafonnent du fait de l'apparition de courants indépendants de la température, souvent liés à des phénomènes de courants de fuite à la surface du détecteur. Ces courants de fuite peuvent avoir pour origine un effet tunnel interbande qui augmente très vite avec la longueur d'onde de coupure. Des performances élevées peuvent être recherchées vers les basses températures, particulièrement dans les ambiances faible flux de photons, en astronomie infrarouge, par exemple.

Dans un premier temps, on a réalisé, selon une technologie plane, les détecteurs photovoltaïques sous forme d'une simple jonction PN dans le matériau semi-conducteur en HgCdTe. Sur la figure 2 annexée, on a représenté un détecteur en HgCdTe à structure plane.

Ce détecteur comprend sur un substrat monocristallin 1 en CdTe une couche monocristalline 3 de $Hg_{1-x}Cd_xTe$ de type P, avec 0 < x <1, comportant une région 5 diffusée de type N constituant la zone active du détecteur. La couche semi-conductrice 3 est surmontée d'une couche 7 isolante, par exemple en ZnS comportant une fenêtre 9 permettant une prise de contact électrique sur la région 5 de type N. La prise de contact est assurée par un plot de contact 11 par exemple en chrome-or. Un tel détecteur est notamment décrit dans "Semiconductors and Semimetals" vol.18, Mercury Cadmium Telluride Chapter 6, pp.201...

Academic Press, 1981.

Malheureusement, ces détecteurs simples à structure plane présentaient des courants d'obscurité $I_o$ trop élevés, donc des résistances dynamiques $R_o$ trop faible, ce qui limitait leur domaine spectral et donc leur utilisation.

Afin d'améliorer les performances des détecteurs photovoltaïques en HgCdTe, on a envisagé de les réaliser sous forme d'hétérojonctions avec une jonction PN à faible largeur de bande interdite et une jonction PN à grande largeur de bande interdite. Dans l'article de P. MIGLIORATO et A.M. WHITE, paru dans Solid State Electronics vol.26, n°1 p.65 à 69 de 1983 et intitulé "Common anion heterojunctions : CdTe-CdHgTe", il est décrit des hétérojonctions de N CdTe/P $Hg_{1-x}Cd_xTe$ avec $0 < x < 1$ et plus généralement des hétérojonctions

$$N\ Hg_{1-x_1}Cd_{x_1}Te/P\ Hg_{1-x_2}Cd_{x_2}Te$$

avec respectivement comme largeur de bande interdite $Eg_1$ et $Eg_2$, $Eg_1$ étant inférieur à $Eg_2$, et dans lesquelles $x_1$ est inférieur à $x_2$.

Ce dernier type d'hétérojonctions peut être schématisé comme représenté sur la figure 3 annexée. Il comprend une couche monocristalline 13 en

$$Hg_{1-x_1}Cd_{x_1}Te .$$

de type P surmontée d'une autre couche monocristalline 15 en

$$Hg_{1-x_2}Cd_{x_2}Te$$

de type P comportant une région implantée ou diffusée 17 de type N.

Dans une telle hétérostructure, le raccordement des bandes d'énergie suit la loi de l'anion commun qui fixe essentiellement la bande de valence. Cette bande de valence n'a pas de discontinuité à l'hétérojonction ; la discontinuité $Eg_2-Eg_1$ est reportée sur la bande de conduction. Par ailleurs, l'hétérojonction est abrupte, c'est-à-dire que l'on passe de façon abrupte de la composition $x_2$ à la composition $x_1$.

Etant donné la discontinuité de la bande de conduction, les photons de grande longueur d'onde ne peuvent être détectés. En effet, les photons d'énergie comprise entre $Eg_2$ et $Eg_1$ ne peuvent être absorbés que dans le matériau de composition $x_1$. Les électrons engendrés lors d'une irradiation de la structure ne peuvent traverser l'hétérojonction car ils rencontrent une barrière de potentiel.

MIGLIORATO et WHITE ont proposé de surmonter cette difficulté par une hétérojonction graduelle qui permet d'effacer la barrière de potentiel s'opposant à la traversée de l'hétérojonction par les électrons. Pour un dopage N graduel suffisamment élevé dans la partie de composition $x_2$, et des variations suffisamment graduelles, à l'hétérojonction de ce dopage et de la composition, la barrière de potentiel disparaît.

Sur la figure 4 annexée, on a représenté, d'une part, les variations du dopage N ($D_N$) en fonction de la profondeur Z (figure 3) de matériau semiconducteur et, d'autre part, les variations de la composition x dudit matériau en fonction de Z.

Bien que très séduisante, une telle solution présente de nombreuses difficultés de réalisation car tous les paramètres doivent être ajustés de manière précise. En effet, les conditions suivantes doivent être remplies :

- la jonction électrique (passage du matériau de type N au matériau de type P) et la jonction métallurgique (maximum de variation de la composition x) doivent être confondues ;
- le dopage $D_N$ de la zone N de composition $x_2$ doit être suffisamment élevé ; et
- la variation de composition x ne doit pas être trop graduelle par rapport la variation du dopage $D_N$.

Il suffit que l'une de ces conditions ne soit pas remplie pour qu'apparaisse une barrière de potentiel s'opposant au passage des électrons à travers l'hétérojonction. Ces électrons étant engendrés, suite à une irradiation, dans le semi-conducteur de composition $x_1$ faible largeur de bande interdite $Eg_1$.

Comme autres détecteurs en HgCdTe connus utilisant une variation continue de la composition x, suivant l'épaisseur de la couche semi-conductrice, on peut citer ceux décrits dans l'article de E.IGRAS et J. PIOTROWSKI "A new CdHgTe Photodiode Type with Protected Junction Surface" paru dans Optica Applicata VI,3 p.99-103 de 1976. Dans ces détecteurs, la valeur maximum de x se trouve sur l'interface avec l'isolant. Mais avec une prise de contact sur HgCdTe de type N à grande largeur de bande interdite, le même problème de perte de sensibilité aux grandes longueurs d'onde subsiste.

La présente invention a justement pour objet un détecteur photovoltaïque en HgCdTe à structure plane et hétérojonction présentant des performances améliorées par rapport aux détecteurs mentionnés ci-dessus. Par ailleurs, son procédé de fabrication est simple à mettre en oeuvre et ne comportent pas d'étapes critiques.

De façon plus précise, l'invention a pour objet un détecteur photovoltaïque à structure plane comportant une première couche semi-conductrice monocristalline en

$$Hg_{1-x_1} Cd_{x_1} Te.$$

d'un premier type de conductivité, $x_1$ étant un nombre compris entre 0 et 1, cette première couche semi-conductrice contenant une première région d'un second type de conductivité, un isolant électrique situé au-dessus de la première couche semi-conductrice et un plot de contact électrique situé sur l'isolant servant à recueillir le signal électrique engendré dans ladite première région, caractérisé en ce qu'une seconde couche semi-conductrice monocristalline en

$$Hg_{1-x_2} Cd_{x_2} Te$$

du premier type de conductivité est interposee entre la première couche semi-conductrice et l'isolant, $x_2$ étant un nombre supérieur à $x_1$, compris entre 0 et 1, cette seconde couche semi-conductrice contenant une seconde région du second type de conductivité, située en regard et au contact de ladite première région, et en ce que le plot de contact s'étend dans un trou traversant ladite seconde région et pénétrant partiellement dans ladite première région de façon à contacter lesdites régions.

Le détecteur de l'invention présente par rapport aux détecteurs de l'art antérieur les avantages suivants :

- une réalisation technologique non critique, en particulier vis-à-vis des profils de dopage et de composition ;

- des performances accrues vers les hautes températures de fonctionnement par suite d'une réduction des courants d'obscurité dépendant de la température;

-des performances accrues à basse température et en ambiance faible flux de photons, par suite de la réduction des courants d'obscurité et notamment des courants de fuites en surface, indépendants de la température.

Le profil de composition entre les semi-conducteurs de compositions $x_1$ et $x_2$ n'est pas critique, il peut être abrupt ou graduel (avec une variation sur une épaisseur de l'ordre du micron). En effet, le conducteur électrique allant jusqu'au semi-conducteur de faible largeur de bande interdite, c'est-à-dire de composition $x_1$, les électrons engendrés dans ce semi-conducteur lors d'un éclairement du détecteur pourront passer librement dans un circuit extérieur, sans l'obstacle de 1 barrière de potentiel décrite précédemment.

De préférence, les première et seconde couches semi-conductrices présentent une conductivité de type P et les première et seconde régions une conductivité de type N.

De façon avantageuse, la première région présente une épaisseur allant de 0,5 à 5 $\mu$m.

Le détecteur photovoltaïque selon l'invention peut être utilisé en l'éclairant par la face avant, c'est-à-dire du côté de l'isolant ou bien en l'éclairant par la face arrière, c'est-à-dire du côté opposé à l'isolant. Dans le premier mode d'utilisation, la zone sensible du détecteur, c'est-à-dire les régions de second type de conductivité N par exemple, ne doit être que partiellement recouverte par la métallisation.

De façon avantageuse, le détecteur selon l'invention comprend des moyens de traitement du signal engendré dans ladite première région.

L'invention a aussi pour objet un procédé de fabrication d'un détecteur photovoltaïque à structure plane et à hétérojonction.

Selon l'invention, ce procédé comprend les étapes suivantes :

(a) dépôt, sur une première couche semiconductrice monocristalline en

$$Hg_{1-x_1} Cd_{x_1} Te$$

d'un premier type de conductivité, $x_1$ étant un 0 et 1, d'une seconde couche semi-conductrice monocristalline en

$$Hg_{1-x_2} Cd_{x_2} Te$$

du premier type de conductivité, $x_2$ étant un nombre supérieur à $x_1$ compris entre 0 et 1,

(b) dépôt d'une première couche d'isolant electrique sur la seconde couche semiconductrice,

(c) ouverture d'une fenêtre dans la première couche d'isolant en vue de réaliser la zone sensible,

(d) dopage, à travers la première couche d'isolant, des première et seconde couches semi-conductrices pour former deux régions superposées d'un second type de conductivité, constituant ladite zone sensible, une première région dans la première couche semi-conductrice et une seconde région dans la seconde couche semi-conductrice,

(e) réalisation d'un trou de contact électrique à l'emplacement de la zone active traversant totalement la seconde couche semi-conductrice et en partie la première couche semi-conductrice,

(f) métallisation du trou de contact électrique.

Ce procédé est simple à mettre en oeuvre et ne présente pas d'étapes critiques.

Selon un mode préféré de mise en oeuvre du procédé de l'invention, on réalise l'étape (d) après l'étape (e), la fenêtre de la première couche d'isolant servant aussi à réaliser le trou de contact. Ceci permet la formation d'une première région notamment de type N de périmètre réduit.

De façon avantageuse, on effectue avant l'étape (f) un surdopage du second type de conductivité dans le fond du trou de contact.

D'autres caractéristiques et avantages de l'invention ressortiront mieux de la description qui va suivre, donnée à titre illustratif et non limitatif.

La description se réfère aux figures annexées sur lesquelles :

- la figure 1, déjà décrite, est une courbe donnant les variations du courant I en fonction de la tension V appliquée aux bornes d'un détecteur photovoltaïque en HgCdTe, cette courbe servant à illustrer les différents paramètres auxquels doit répondre un tel détecteur,

- la figure 2, déjà décrite, représente schématiquement un détecteur photovoltaïque en HgCdTe, monojonction et à structure plane, illustrant l'état de la technique,

- la figure 3, déjà décrite, est une vue schématique d'une hétérojonction en HgCdTe, illustrant l'état de la technique,

- la figure 4, déjà décrite, donne d'une part les variations du dopage N ($D_N$) en fonction de la profondeur (Z) d'un matériau semi-conducteur à hétérostructure et, d'autre part, les variations de la composition x dudit matériau en fonction de la profondeur Z;

- la figure 5 représente schématiquement un détecteur photovoltaïque selon l'invention à éclairage "face avant, face arrière",

- la figure 6 représente schématiquement un détecteur photovoltaïque selon l'invention à éclairage "face arrière",

- la figure 7 représente schématiquement un détecteur photovoltaïque selon l'invention équipé d'un système de traitement du signal engendré dans la zone active du détecteur, incorporé,

- les figures 8 à 15 illustrent les différentes étapes de fabrication du détecteur photovoltaïque de la figure 5,

- les figures 16 à 20 illustrent les différentes étapes de fabrication du détecteur photovoltaïque de la figure 6.

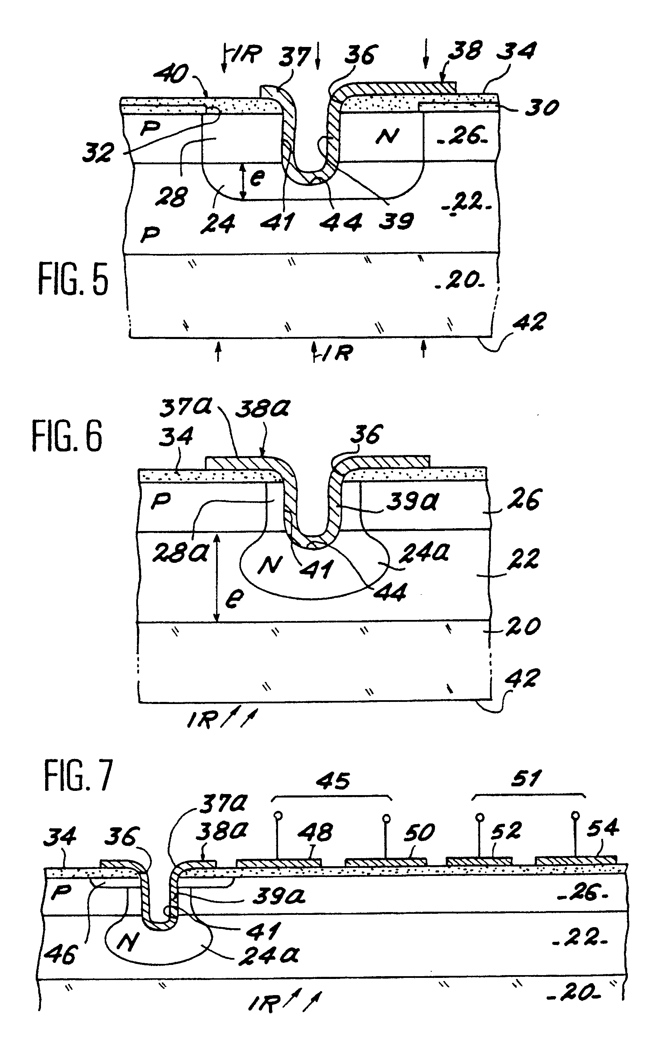

Sur la figure 5, on a représenté un premier mode de réalisation d'un détecteur photovoltaïque à structure plane conformément à l'invention.

Ce détecteur comprend un substrat monocristallin 20 transparent aux rayonnements détecter. Dans le cas particulier de détection de rayonnements infrarouges, le substrat est réalisé par exemple en saphir ou en tellurure de cadmium. Ce substrat 20 est recouvert d'une première couche semi-conductrice 22, monocristalline, en

$$Hg_{1-x_1} Cd_{x_1} Te$$

avec $0 < x < 1$. En particulier, $x_1$ peut être tel que $0,2 \; x_1 < 0,3$ et par exemple égale à 0,2 ; la valeur de $x_1$ fixe la longueur d'onde centrale du rayonnement lumineux détectable par le détecteur. Cette couche semi-conductrice 22 présente une conductivité de type P. Son épaisseur peut varier de 5 à 15 $\mu$m. Cette couche 22 renferme une région 24, diffusée ou implantée, de type N, constituant l'essentiel de la zone active du détecteur photovoltaïque. Cette région 24 présente une épaisseur e allant de 0,5 à 5 $\mu$m.

La couche semi-conductrice 22 est recouverte d'une couche semi-conductrice 26, monocristalline, en

$$Hg_{1-x_2}Cd_{x_2}Te,$$

avec $0 < x_2 < 1$. La composition $x_2$ qui la composition $x_1$ peut être telle que est supérieur 0,3 $x_2$ 0,8. La valeur de $x_2$ dépend de l'application envisagée. Pour simplement une bonne caractéristique $I = f(v)$ (figure 1) du détecteur $x_2$ peut être égal à 0,3 ou 0,4. Pour un détecteur équipé d'un circuit électronique de traitement du signal engendré dans la zone active, $x_2$ peut valoir 0,7 et même aller jusqu'à 0,8. Cette couche semi-conductrice 26 présente une conductivité de type P. Son épaisseur peut varier de 0,5 à 5 $\mu$m. Cette couche semi-conductrice 26 renferme une région 28 de type N, diffusée ou implantée. Cette région 28 de type N fait aussi partie de la zone sensible du détecteur photovoltaïque. Les deux régions de type N 24 et 28 sont superposées et contiguës.

La deuxième couche semi-conductrice 26 est recouverte d'une première couche d'isolant 30, par exemple en sulfure de zinc ou en oxyde de silicium (SiO ou SiO2). Cette couche d'isolant 30 est pourvue d'une ouverture 32 de mêmes dimensions que les régions de type N du détecteur. Ce premier isolant 30 est recouvert d'un second isolant 34 de même nature que le premier isolant 30. Ces deux couches d'isolant 30 et 34 présentent une épaisseur d'environ 0,5 $\mu$m.

Le second isolant 34 est équipé d'une ouverture 36 permettant une prise de contact électrique dans la zone active du détecteur, c'est-à-dire dans les régions de type N. La prise de contact est assurée par un plot de contact électrique 38 logé dans un trou de contact électrique 41 pratiqué dans la zone sensible du détecteur. Ce plot de contact 38 est formé d'une partie 37 située au-dessus du second isolant 34 et d'une partie 39 traversant de part en part la région de type N 28 et partiellement la région de type N 24. Ce plot conducteur 38 peut être réalisé de deux couches superposées, une couche de chrome d'environ 25 nm et une couche d'or d'environ 1 $\mu$m.

Le détecteur représenté sur la figure 5 est fait pour être éclairé soit par la face avant 40, c'est-à-dire du côté de l'isolant 34, soit par la face arrière 42, c'est-à-dire du côté libre du substrat 20. Afin que la zone active ou régions N du détecteur puisse détecter un rayonnement, symbolisé par les flèches, par sa face avant 40, la partie 37 en surface du plot conducteur 38 ne doit pas recouvrir totalement ladite zone active (partie gauche de la figure 5).

Dans ce mode de réalisation, le détecteur selon l'invention peut avantageusement ne pas comporter de substrat 20. Dans ce cas, la couche semi-conductrice 22 présentera une épaisseur supérieure 15 $\mu$m et par exemple égale à 500 $\mu$m.

Par ailleurs, les couches semi-conductrices 22 et 26 peuvent présenter une conductivité de type N, les régions diffusées ou implantées, formant la zone sensible du détecteur, étant alors de type P.

Sur la figure 6, on a représenté un second mode de réalisation d'un détecteur photovoltaïque à structure plane selon l'invention. Les parties de ce détecteur identiques en tout point à celles du détecteur représenté sur la figure 5 porteront les mêmes références. Les parties de structure différentes mais jouant le même rôle porteront les mêmes références suivies d'un a.

Le détecteur représenté sur la figure 6 comprend, comme précédemment, un substrat monocristallin 20 transparent aux rayonnements à détecter, recouvert d'une première couche semi-conductrice 22 de type P monocristalline en

$$Hg_{1-x_1}Cd_{x_1}Te,$$

avec $0 < x_1 < 1$, renfermant une région, diffusée ou implantée, de type N 24. Cette région N présente une épaisseur allant de 0,5 à 5 $\mu$m. La couche semi-conductrice 22 est recouverte d'une seconde semi-conductrice 26 monocristalline en

$$Hg_{1-x_2}Cd_{x_2}Te,$$

avec $0 < x_1 < x_2 < 1$, de type P. Cette couche semi-conductrice 26 renferme une région de type N 28a située au-dessus et au contact de la région de type N 24a située dans la première couche semi-conductrice 22.

La seconde couche semi-conductrice 26 est recouverte d'une couche isolante 34 comportant une ouverture 36 permettant la prise de contact électrique dans la zone active du détecteur. La prise de contact électrique est assurée par un plot 38a ayant une partie 37a située au-dessus de l'isolant 34 et une partie 39a traversant de part en part la région de type N 28a et partiellement la région de type N 24a.

Le détecteur de la figure 6, de structure plus simple que celle du détecteur de la figure 5, et en particulier ne comportant qu'une seule couche d'isolant, est fait pour être utilisé en éclairant uniquement le détecteur par la face arrière 42 (côté libre du substrat). Dans ces conditions, la partie 37a du plot de contact 38a surmontant l'isolant 34 peut recouvrir totalement la zone sensible ou régions de type N du détecteur. Dans ce mode de réalisation, le périmètre de la région de type N 28a est réduit par rapport à celle du détecteur de la figure 5. Par ailleurs, la forme de la région de type N 24a de ce détecteur est différente de celle représentée sur la figure 5.

Comme précédemment, il est éventuellement possible de supprimer le substrat 20. Dans ce cas, compte tenu de l'éclairage uniquement par la face arrière, la couche semi-conductrice doit présenter une épaisseur relativement faible, de l'ordre de 10 $\mu$m.

Les différences de structure entre le détecteur de la figure 5 et le détecteur de la figure 6 sont liées à leur procédé de fabrication légèrement différent, notamment en ce qui concerne la formation des régions de type N de ces détecteurs, comme on le verra ultérieurement.

Les détecteurs photovoltaïques selon l'invention, représentés sur les figures 5 et 6, présentent des performances accrues, aussi bien aux hautes températures de fonctionnement qu'aux basses températures de fonctionnement en ambiance de faible flux de photons, grâce à une réduction importante des sources de courant d'obscurité. Ces courants d'obscurité dépendant exponentiellement de la largeur de bande interdite des matériaux semi-conducteurs, sont en particulier réduits grâce à l'utilisation de deux couches semi-conductrices de composition x différentes, la couche de composition la plus faible $x_1$ étant contiguë au substrat et la couche de composition $x_2$ la plus forte étant contiguë à l'isolant 34.

En outre, en utilisant une épaisseur e de la région de type N 24 ou 24a du matériau de composition $x_1$ inférieure la longueur de diffusion des trous dans ce matériau, et par exemple comprise entre 0,5 et 5 $\mu$m suivant la valeur de $x_1$, on peut encore diminuer les sources de courant d'obscurité.

Enfin, pour encore réduire les sources de courant d'obscurité, on peut prévoir un surdopage N$^+$ au voisinage immédiat de la prise de contact électrique, c'est-à-dire dans le fond 44 (figures 5 et 6) du trou de contact électrique 41. En particulier, la concentration en ions dopants de type N des couches semi-conductrices 24 et 28 peut être comprise entre $10^{15}$ et $10^{17}$ at/cm$^3$ et la concentration de ces mêmes ions dans le fond 44 du trou de contact 41 peut être supérieure à $10^{18}$ at/cm$^3$.

Sur la figure 7, on a représenté un détecteur photovoltaïque selon l'invention pourvu d'un système de traitement du signal incorporé. Le détecteur est du type à éclairage par la face arrière, et peut détecter un rayonnement infrarouge de 10 $\mu$m.

Il comprend, comme précédemment, une couche semi-conductrice 22 en

$$Hg_{1-x_1} Cd_{x_1} Te$$

avec $0 < x_1 < 1$ et notamment en $Hg_{0,8}Cd_{0,2}Te$ de type P contenant une région N diffusée ou implantée 24a, une seconde couche semi-conductrice en

$$Hg_{1-x_2} Cd_{x_2} Te$$

avec $0 < x_1 < x_2 < 1$ et par exemple $0,2 < x_2 < 1$.

La composition $x_2$ est choisie uniquement en fonction d'impératifs purement électriques, tels que, par exemple, la plus grande largeur de bande interdite $Eg_2$ possible, afin de rendre la réalisation des circuits de traitement la moins critique possible. En effet, la couche semi-conductrice 26 est réservée au traitement du signal produit dans la zone active du détecteur. Elle présente une épaisseur allant de 0,5 à 5 $\mu$m.

Le détecteur photovoltaïque comprend encore un isolant 34 (ZnS par exemple) muni d'une ouverture 36 servant à la prise de contact dans la zone sensible du détecteur (régions N). La prise de contact est assurée par un plot de contact électrique 38a logé dans un trou de contact 41. Comme précédemment, ce plot de contact 38a comprend une partie 39a traversant la couche semi-conductrice 26 et pénétrant

7

partiellement dans la couche semi-conductrice 22.

Le traitement du signal engendré principalement dans la région de type N 24a de composition $x_1$ peut être détecté par un transistor de type N MOS 45 couplé à un dispositif à transfert de charge 51 du type IRCCD réalisés dans la couche 26 de composition $x_2$. Un exemple de système de traitement du signal, incorporé, à un détecteur photovoltaïque a notamment été décrit dans un article de KOCH et PHILLIPS - SBRC-paru dans Proceeding, 1984 IEDM Conference- San Francisco-intitulé "Monolithic Intrinsic N MOS HgCdTe IRCCD's with on chip signal processing".

Le transistor N MOS 45 comprend une source 46 de type N, obtenue par diffusion de mercure ou implantation d'ions dans la couche semi-conductrice 26 de composition $x_2$, une électrode de grille 48 située sur l'isolant 34 et un drain induit dans la couche 26 comportant une électrode de drain 50 située aussi sur l'isolant 34 et parallèlement à l'électrode de grille 48. L'électrode de grille 48 et l'électrode de drain 50 peuvent être réalisées en chrome-or par exemple.

Le dispositif à transfert de charge 51 comprend une grille dè transfert, servant au transfert des charges dans la couche 26 et comportant une électrode de grille 52, et un = électrode de multiplexage 54 des charges transférées. Les électrodes de grille 52 et de multiplexage 54 sont situées toutes les deux sur l'isolant 34.

Le couplage entre la zone de détection 24a du détecteur et la source du transistor N MOS ou circuit d'entrée du circuit de traitement est réalisé directement par la partie 37a du plot de contact électrique 38a située au-dessus de la source 46 du transistor et de la région de type N 24a.

On va maintenant décrire les procédés de fabrication des deux modes de réalisation du détecteur photovoltaïque selon l'invention décrits précédemment.

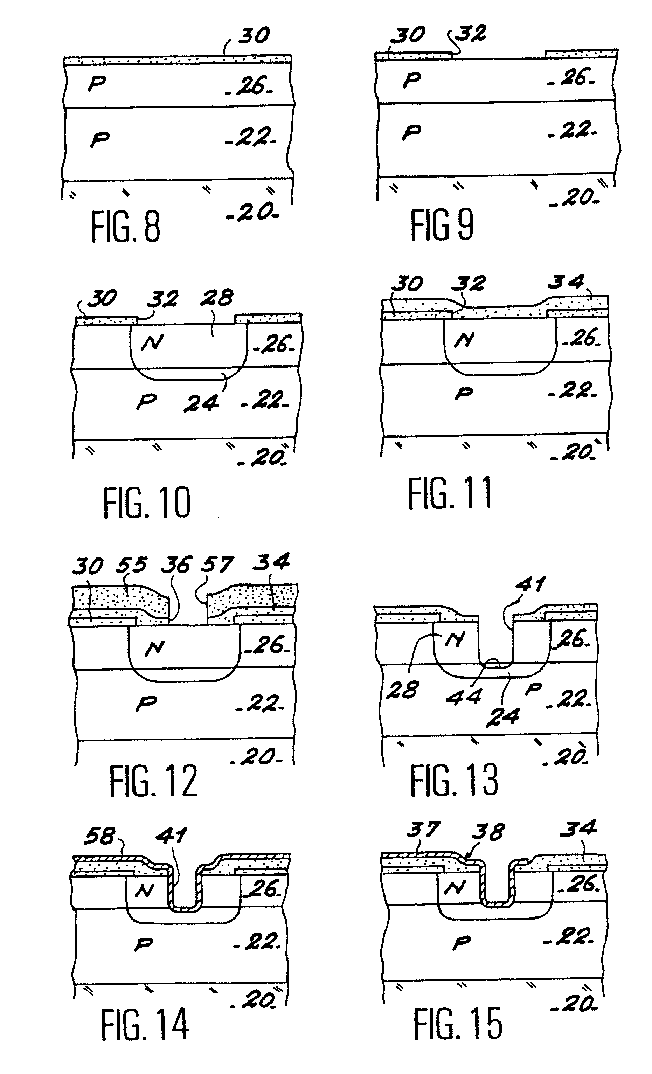

Sur les figures 8 à 15, on a représenté les différentes étapes de fabrication du détecteur représenté sur la figure 5.

La première étape de ce procédé consiste, comme représenté sur la figure 8, à déposer sur un substrat monocristallin 20, transparent aux rayonnements à détecter, par exemple en saphir ou en CdTe pour détecter des infrarouges, une première couche semi-conductrice monocristalline 22. Cette couche 22 en

$$Hg_{1-x_1}Cd_{x_1}Te,$$

avec $x_1$ compris entre 0 et 1, et par exemple egal à 0,2, peut être formée par épitaxie à partir du substrat 20. Les techniques d'épitaxie utilisables, bien connues de l'homme de l'art, sont l'épitaxie en phase liquide, l'épitaxie par jets moléculaires, l'épitaxie par pulvérisation cathodique en plasma de mercure ou à partir de composés organo-métalliques de cadmium et de tellure. Cette couche semi-conductrice 22 de type P présente par exemple une épaisseur allant de 5 à 15 $\mu$m.

En cas de suppression du substrat 20, la couche semi-conductrice 22 est réalisée sous forme massive par croissance Bridgman, cristallisation en phase solide (CPS) ou THM (Traveller Heating Method en terminologie anglosaxonne).

Sur la couche semi-conductrice 22, on dépose ensuite par épitaxie à partir de cette couche, une seconde couche semi-conductrice 26, monocristalline, en

$$Hg_{1-x_2}Cd_{x_2}Te$$

de type P, $x_2$ étant un nombre supérieur à $x_1$, compris entre 0 et 1 et par exemple égal à 0,4. La technique d'épitaxie utilisable pour former cette couche 26 peut être l'une de celles citées précédemment. Cette couche semi-conductrice 26 présente une épaisseur allant de 0,5 à 5 $\mu$m.

La seconde couche semi-conductrice 26 est ensuite recouverte d'une première couche isolante 30 ayant une épaisseur d'environ 0,5 $\mu$m. Cette couche isolante, par exemple en sulfure de zinc ou en oxyde de silicium, peut être déposée par un procédé de dépôt chimique en phase vapeur (CVD).

L'étape suivante du procédé consiste, comme représenté sur la figure 9, à ouvrir dans la première couche d'isolant 30, une ouverture 32 dont les dimensions définissent celles de la zone sensible du détecteur à réaliser. La fenêtre 32 présente par exemple un diamètre de 20 $\mu$m. L'ouverture de la fenêtre 32 peut être réalisée en utilisant un masque de résine, obtenu selon les procédés classiques de photolithographie, et en éliminant la région de l'isolant non masquée par exemple par attaque chimique. Comme agent d'attaque, on peut utiliser, dans le cas d'une couche 32 en sulfure de zinc, l'acide chlorhydrique.

L'étape suivante du procédé consiste, comme représenté sur la figure 10, à faire diffuser ou implanter des ions dans les couches semi-conductrices 26 et 22, en utilisant la couche d'isolant 30 gravée comme masque de diffusion ou d'implantation.

Cette zone sensible est formée de deux régions de type N 24 et 28 respectivement de composition $x_1$ et $x_2$. La région de type N 28 présente une épaisseur égale à celle de la couche semi-conductrice 26 dans laquelle elle est formée et la région de type N 24 une épaisseur inférieure à celle de la couche 22 dans laquelle elle est formée. Par exemple, la région 24 présente une épaisseur comprise entre 0,5 et 5 μm. L'épaisseur totale de la zone sensible du détecteur est déterminée, dans le cas d'une diffusion d'ions, par la température et la durée de cette diffusion et, dans le cas d'une implantation ionique, par l'énergie et la dose d'implantation.

L'étape suivante du procédé consiste, comme représenté sur la figure 11, à recouvrir l'ensemble de la structure d'une seconde couche isolante 34 de 0,5 μm. Cette couche isolante, par exemple en sulfure de zinc ou en oxyde de silicium, peut être déposée par un procédé de dépôt chimique en phase vapeur (CVD).

Ensuite, par les procédés classiques de photolithographie, on réalise, comme représenté sur la figure 12, un masque de résine positive 55 sur la couche d'isolant 34, munie d'une ouverture 57. La résine utilisée est une résine phénol-formaldéhyde telle que la résine AZ 1350 de chez Shippley.

L'ouverture 57, positionnée juste au-dessus de la zone sensible (régions N) du détecteur présente par exemple un diamètre de 5 μm. Elle permet de définir les dimensions du trou de contact électrique à réaliser.

On effectue, ensuite, une ouverture 36 dans la couche d'isolant 34 par élimination de la région de l'isolant, non recouverte de résine. Cette élimination peut être réalisée par attaque chimique ou usinage ionique. Dans le cas d'une couche d'isolant 34 en sulfure de zinc, on peut réaliser une attaque chimique avec comme agent d'attaque l'acide chlorhydrique.

Comme représenté sur la figure 13, on élimine ensuite, sur toute l'épaisseur de la région de type N 28, la zone de cette région 28 non masquée par l'isolant 34 et la résine 55 et sur une épaisseur donnée, inférieure à celle de la région de type N 24, la zone de cette région 24 non masquée par l'isolant et la résine, afin de former le trou de contact électrique 41 du détecteur.

Le diamètre du trou de contact 41 formé est égal à celui de la fenêtre 57 du masque de résine 55 et par exemple égale à 5 μm et la profondeur de ce trou est par exemple égal à 5 μm. L'ouverture du trou de contact 41 peut être réalisée par usinage ionique. Cet usinage ionique permet aussi d'éliminer en partie le masque de résine 55. Le masque de résine doit donc présenter une épaisseur importante, supérieure à 2 μm, afin de pouvoir faire écran malgré son usinage aux ions abrasifs tels que les ions d'argon. La vitesse d'usinage du matériau semi-conducteur en HgCdTe est de l'ordre de 150 nm/min. et la vitesse de gravure du masque de résine 55 de 30 nm/min.. La gravure par usinage ionique permet la réalisation de trous de contact de profondeur relativement importante (5 μm). Dans le cas où l'on désirerait graver ds trous moins profonds, la gravure chimique, bien que moins précise, pourrait être utilisée.

Après nettoyage des restes de résine, par voie chimique, on effectue comme représenté sur la figure 14, une métallisation de la structure, notamment par pulvérisation cathodique. Cette métallisation 58 peut être formée de deux couches empilées, une couche de chrome puis une couche d'or d'épaisseurs respectives 25 nm et 1 μm. Le dépôt par pulvérisation cathodique permet d'obtenir une métallisation bicouche 58 d'épaisseur uniforme recouvrant le fond et les flancs du trou de contact 41.

L'étape suivante du procédé, comme représenté sur la figure 15, consiste à graver la métallisation bicouche 58 pour donner la forme finale au plot de contact électrique 38. Cette gravure peut être réalisée par usinage ionique ou attaque chimique, à travers un masque de résine, réalisé selon les procédés classiques de photolithographie. Dans le cas d'une attaque chimique on utilise, pour une métallisation chrome/or, l'iodure de potassium pour l'attaque de l'or et une solution acqueuse de $NaOH + K_3FeCN_6$ pour le chrome comme agent d'attaque. La partie 37 du plot électrique recouvrant l'isolant 34 permet la connexion du détecteur photovoltaïque obtenu à un circuit électrique de traitement, qui peut être notamment celui représenté sur la figure 7.

Dans ce cas particulier de structure monolithique à système de traitement incorporé, les électrodes de grille 48 et de drain 50 du transistor N MOS 45, d'une part, et les électrodes de transfert 52 et de multiplexage 54 du dispositif à transfert de charges, d'autre part, peuvent être formées par la métallisation 58 lors de sa gravure pour réaliser le plot de contact électrique 38.

Afin d'augmenter les performances du détecteur photovoltaïque obtenu en réduisant les sources de courants d'obscurité, on peut effectuer, après formation du trou de contact électrique 41 (figure 13), un surdopage de type $N^+$ du fond 44 de celui-ci. Ce surdopage peut être réalisé par une implantation d'ions BORE à une dose de $5.10^{14}$. $t/cm^3$ et une énergie de 100 keV.

On va maintenant décrire le procédé de fabrication du détecteur photovoltaïque selon l'invention, à éclairage par la face arrière, représenté sur la figure 6.

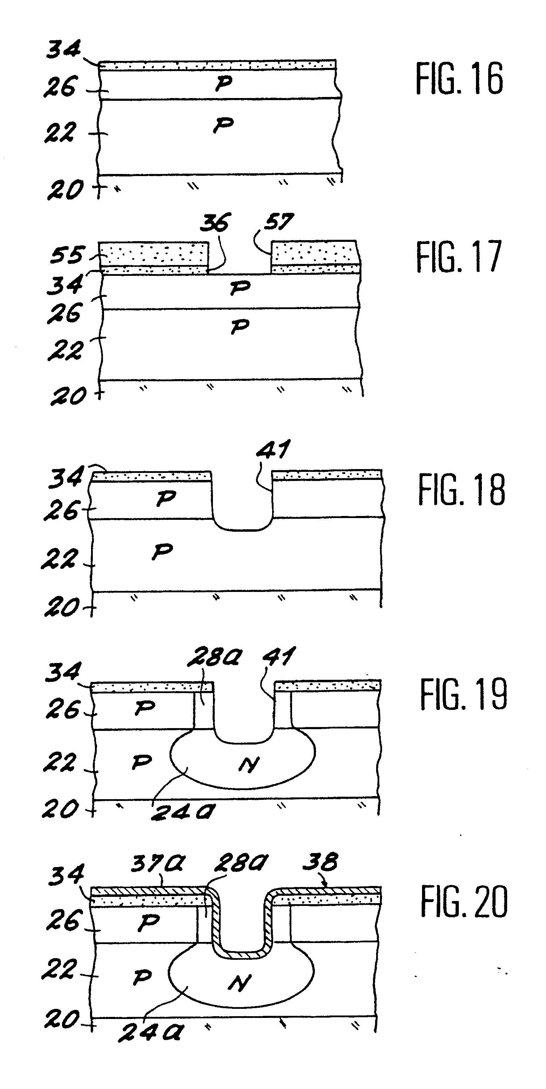

Comme représenté sur la figure 16, on réalise, comme précédemment, les dépôts successifs par épitaxie, de deux couches semi-conductrices 22 et 26 de type P sur un substrat monocristallin 20 par exemple en tellurure de cadmium. La couche 22 est réalisée en

$$Hg_{1-x_1} Cd_{x_1} Te$$

et la couche 26 en

$$Hg_{1-x_2} Cd_{x_2} Te$$

avec $0 < x_1 < x_2 < 1$. Dans le cas éventuel de suppression du substrat 20, la couche semi-conductrice 22 peut être obtenue par croissance cristalline, selon la méthode de Bridgman ou CPS, suivie d'un amincissement final jusqu'à une épaisseur de l'ordre de 10 $\mu$m pour permettre l'éclairage du détecteur par sa face arrière.

Sur la couche semi-conductrice 26, on dépose ensuite directement la couche d'isolant 34, par exemple en ZnS. Cette couche 34, déposée notamment par CVD présente une épaisseur de 0,5 $\mu$m.

On réalise ensuite, comme représenté sur la figure 17, selon les procédés classiques de photolithographie, un masque de résine 55 d'au moins 2 $\mu$m d'épaisseur, présentant une ouverture 57 d'un diamètre de 5 $\mu$m par exemple. Le diamètre de l'ouverture 57 permet de définir les dimensions du trou de contact électrique à réaliser. A travers ce masque de résine 55, on forme ensuite une ouverture 36 dans la couche d'isolant 34 par élimination de la région de cette couche d'isolant non recouverte par la résine. Cette élimination est réalisée par attaque chimique ou usinage ionique.

L'étape suivante du procédé consiste à réaliser un usinage ionique de la couche semi-conductrice 26 et de la couche semi-conductrice 22 en utilisant le masque de résine 55 comme masque à cette usinage. Cet usinage est réalisé sur toute l'épaisseur de la couche 26 et sur une partie seulement de la couche 22, sur 0,5 à 5 $\mu$m d'épaisseur. Il permet aussi d'éliminer en partie le masque de résine 55. Le trou de contact électrique 41, ainsi formé, représenté sur la figure 18, présente un diamètre de 5 $\mu$m et une profondeur d'environ 5 $\mu$m. La vitesse de gravure par usinage ionique des couches semi-conductrices 22 et 26 est réalisée à une vitesse de 150 nm/min. et la gravure de la résine restante à 30 nm/min.

Après nettoyage des restes de résine par voie chimique, on réalise une diffusion ou une implantation d'ions dans le trou de contact 41, à travers la couche d'isolant 34 gravée, pour former la zone sensible du détecteur photovoltaïque. Cette zone sensible, comme représentée sur la figure 19, est formée de deux régions de type N 28a et 24a dont la composition x est celle respectivement des couches semi-conductrices 26 et 22 dans lesquelles elles sont définies.

La formation des régions N 28a et 24a, par diffusion ou implantation d'ions dans le trou de contact électrique 41 permet, par rapport au procédé décrit en référence aux figures 8-15, de réduire le périmètre de la région N 28a formée dans la couche semi-conductrice de composition $x_2$ la plus forte. Pour permettre l'inversion de conductivité, on peut utiliser comme ions des ions de mercure dans le cas de la diffusion, et des ions de bore dans le cas de l'implantation ionique.

La diffusion ou l'implantation de ces ions, et donc de la forme des régions N obtenues, dépend de la composition x de la couche semi-conductrice dans laquelle ils sont diffusés ou implantés. En particulier, dans le cas de la diffusion d'ions de mercure, l'article de M. BROWN et de A.F.W. WILLOUGBY, publié dans le Journal of Crystal Growth 59, 1982, p.27-39 intitulé "Diffusion in $Cd_xHg_{1-x}Te$ and related materials", montre que le mercure diffuse environ 10 fois plus rapidement dans un matériau semi-conducteur de composition $x = 0,2$ que dans un matériau $x = 0,4$, dans les mêmes conditions opératoires.

Par ailleurs, la demanderesse a observé que, lorsque la composition x du matériau semiconducteur varie de 0,2 à 0,3, la profondeur de la région N diffusée obtenue dans les mêmes conditions de diffusion de mercure, varie de plus d'un facteur 2.

Pratiquement, si on réalise, suivant l'invention une diffusion latérale de type N sur une dizaine de micromètres dans le matériau semi-conducteur de composition $x_1 = 0,2$, la diffusion correspondante, dans le matériau semi-conducteur de composition $x_2 = 0,4$, sera de l'ordre de 1 $\mu$m. La région N formée dans le matériau semi-conducteur de composition $x_1$ pourra pratiquement être qualifiée de région "enterrée" eu égard à la grande différence de surface développée avec la région N du matériau semi-conducteur de

composition $x_2$.

Après formation des régions de type N 24a et 28a, on effectue éventuellement une implantation d'ions de bore afin de surdoper le fond du trou de contact 41. Ensuite, comme représenté sur la figure 20, on réalise une métallisation de la surface de la structure, formée par exemple de deux couches, une couche en or et une couche en chrome, que l'on grave afin de former le plot de contact électrique 38a du détecteur photovoltaïque. Dans le cas présent la partie 37a du plot de contact 38a, située sur la couche d'isolant 34, peut recouvrir totalement la zone active du détecteur sans contrainte pour celui-ci, étant donné que le détecteur est fait pour être éclairé par sa face arrière, c'est-à-dire du côté du substrat 20.

Dans le cas d'un détecteur photovoltaïque à éclairage par l'avant, la formation des régions N après réalisation du trou de contact, comme décrit en référence aux figures 17-19 relatives à la fabrication d'un détecteur à éclairage par l'arrière, n'est pas souhaitable, la forme et les dimensions de ces régions N risquant d'être mal contrôlées.

La structure, représentée sur la figure 20, est beaucoup plus compacte et plus simple que celle obtenue précédemment (figure 15) ; elle est parfaitement bien adaptée à la réalisation d'une mosaïque de détecteurs photovoltaïques, d'infrarouges notamment, très dense, à grand nombre de points.

## Revendications

1. Détecteur photovoltaïque à structure plane comportant une première couche semi-conductrice (22) monocristalline en

$$Hg_{1-x_1} Cd_{x_1} Te$$

d'un premier type de conductivité, $x_1$ étant un nombre compris entre 0 et 1, cette première couche semi-conductrice (22) contenant une première région (24, 24a) d'un second type de conductivité, un isolant électrique (30, 34) situé au-dessus de la première couche semi-conductrice (22) et un plot de contact électrique (38, 38a) situé sur l'isolant (30, 34), servant à recueillir le signal électrique engendré dans ladite première région (24, 24a), caractérisé en ce qu'une seconde couche semi-conductrice (26) monocristalline en

$$Hg_{1-x_2} Cd_{x_2} Te$$

du premier type de conductivité est interposée entre la première couche semi-conductrice (22) et l'isolant (30, 34), $x_2$ étant un nombre supérieur à $x_1$ compris entre 0 et 1, cette seconde couche semi-conductrice (26) contenant une seconde région (28, 28a), du second type de conductivité, située en regard et au contact de ladite première région (24, 24a), et en ce que le plot de contact (38, 38a, 39) s'étend dans un trou (41) traversant ladite seconde région (28, 28a) et pénétrant partiellement dans ladite première région (24, 24a) de façon à contacter lesdites régions.

2. Détecteur photovoltaïque selon la revendication 1, caractérisé en ce que la première couche semi-conductrice (22) repose sur un substrat monocristallin (20).

3. Détecteur photovoltaïque selon la revendication 1 ou 2, caractérisé en ce que les première et seconde couches semi-conductrices (22, 26) présentent une conductivité de type P et les première et seconde régions (24, 24a, 28, 28a) une conductivité de type N.

4. Détecteur photovoltaïque selon l'une quelconque des revendications 1 à 3, caractérisé en ce que la première région (24, 24a) présente une épaisseur (e) allant de 0,5 à 5 $\mu$m.

5. Détecteur photovoltaïque selon l'une quelconque des revendications 1 à 4, caractérisé en ce que $x_1$ est égal à 0,2 et $x_2$ égal à 0,4.

6. Détecteur photovoltaïque selon l'une quelconque des revendications 1 à 5, caractérisé en ce que le

EP 0 229 574 B1

plot conducteur (38) ne recouvre que partiellement les première et seconde régions (24a, 28a).

7. Détecteur photovoltaïque selon l'une quelconque des revendications 1 à 6, caractérisé en ce qu'il comprend des moyens (45, 51) intégrés de traitement du signal engendré dans ladite première région.

8. Procédé de fabrication d'un détecteur photovoltaïque à structure plane selon la revendication 1, caractérisé en ce qu'il comprend les étapes suivantes :
   (a) dépôt, sur une première couche semi-conductrice (22) monocristalline en

$$Hg_{1-x_1} Cd_{x_1} Te$$

d'un premier type de conductivité, $x_1$ étant un1 nombre compris entre 0 et 1, d'une seconde couche semi-conductrice (26) monocristalline en

$$Hg_{1-x_2} Cd_{x_2} Te$$

du premier type de conductivité, $x_2$ étant un nombre supérieur à $x_1$ compris entre 0 et 1,
   (b) dépôt d'une première couche d'isolant électrique (30, 34) sur la seconde couche semi-conductrice (26),
   (c) ouverture d'une fenêtre (32, 36) dans la première couche d'isolant (30, 34) en vue de réaliser la zone sensible (24, 28, 24a, 28a),
   (d) dopage travers la première couche d'isolant (30, 34) des première et seconde couches semi-conductrices (22, 26) pour former deux régions superposées d'un second type de conductivité, constituant ladite zone sensible, une première région (24, 24 ) dans la première couche semi-conductrice (22) et une seconde région (28, 28a) dans la seconde couche semi-conductrice (26),
   (e) réalisation d'un trou de contact électrique (41) à l'emplacement de la zone active traversant totalement la seconde couche semi-conductrice (26) et en partie la première couche semi-conductrice (22),
   (f) métallisation du trou de contact électrique (41).

9. Procédé de fabrication selon la revendication 8, caractérisé en ce que l'on effectue, entre les étapes (d) et (e) successives le dépôt d'une seconde couche d'isolant (34) et l'ouverture d'une fenêtre (36) dans cette seconde couche d'isolant en vue de réaliser le trou de contact (41).

10. Procédé de fabrication selon la revendication 8, caractérisé en ce que l'on réalise l'étape (d) après l'étape (e), la fenêtre (36) de la première couche d'isolant servant aussi à réaliser le trou de contact (41).

11. Procédé de fabrication selon l'une quelconque des revendications 8 à 10, caractérisé en ce que l'on effectue avant l'étape (f), un surdopage du second type de conductivité dans le fond (44) du trou de contact (41).

## Claims

1. Photovoltaic detector with a planar structure having a first

$$Hg_{1-x_1} Cd_{x_1} Te$$

monocrystalline semiconductor layer (22) with a first conductivity type, $x_1$ being a number between 0 and 1, said first semiconductor layer (22) containing a first region (24,24a) of a second conductivity type, an electrical insulant (30,34) located above the first semiconductor layer (22) and an electric contact element (38,38a) located on the insulant (30,34) serving to collect the eleectric signal produced in said first region (24,24a), characterized in that a second

12

$$Hg_{1-x_2}Cd_{x_2}Te$$

monocrystalline semiconductor layer (26) of the first conductivity type is interposed between the first semiconductor layer (22) and the insulant (30,34), $x_2$ being a number exceeding $x_1$, between 0 and 1, said second semiconductor layer (26) containing a second region (28,28a) of the second conductivity type facing and in contact with said first region (24,24a) and in that the contact element (38,38a,39) extends into a hole (41) traversing said second region (28,28a) and partly penetrating said first region (24,24a) so as to contact said regions.

2. Photovoltaic detector according to claim 1, characterized in that the first semiconductor layer (22) rests on a monocrystalline substrate (20).

3. Photovoltaic detector according to claims 1 or 2, characterized in that the first and second semiconuductor layers (22,26) have a type P conductivity and the first and second regions (24,24a,28,28a) a type N conductivity.

4. Photovoltaic detector according to any one of the claims 1 to 3, characterized in that the first region (24,24a) has a thickness (e) between 0.5 and 5 $\mu$m.

5. Photovoltaic detector according to any one of the claims 1 to 4, characterized in that $x_1$ is equal to 0.2 and $x_2$ equal to 0.4.

6. Photovoltaic detector according to any one of the claims 1 to 5, characterized in that the contact element (38) only partly covers the first and second regions (24a,28a).

7. Photovoltaic detector according to any one of the claims 1 to 6, characterized in that it comprises integrated means (45,51) for processing the signal produced in the first region.

8. Process for the production of a planar structure photovoltaic detector according to claim 1, characterized in that it comprises the following stages:
   (a) deposition on a first

$$Hg_{1-x_1}Cd_{x_1}Te$$

monocrystalline semiconductor layer (22) of a first conductivity type, $x_1$ being a number between 0 and 1, of a second

$$Hg_{1-x_2}Cd_{x_2}Te$$

monocrystalline semiconductor layer (26) of the first conductivity type, $x_2$ being a number greater than $x_1$ and between 0 and 1.
   (b) deposition of a first electric insulant layer (30,34) on the second semiconductor layer (26),
   (c) opening a window (32,36) in the first insulant layer (30,34) with a view to realizing the sensitive zone (24,28,24a,28a),
   (d) doping through the first insulant layer (30,34) first and second semiconductor layers (22,26) for forming two superimposed regions of a second conductivity type constituting said sensitive zone, a first region (24,24a) in the first semiconductor layer (22) and a second region (28,28a) in the second semiconductor layer (26),
   (e) formation of an electric contact hole (41) at the location of the active zone completely traversing the second semiconductor layer (26) and in part the first semiconductor layer (22),
   (f) metallization of the electric contact hole (41).

9. Production process according to claim 8, characterized in that between stages (d) and (e) is successively performed the deposition of a second insulating layer (34) and the opening of a window (36) in the latter with a view to forming the contact hole (41).

10. Production process according to claim 8, characterized in that stage (d) is performed after stage (e), the window (36) of the first insulating layer also being used for producing the contact hole (41).

11. Production process according to any one of the claims 8 to 10, characterized in that before stage (f), there is an overdoping of the second conductivity type in the bottom (44) of the contact hole (41).

## Ansprüche

1. Photovoltaischer Detektor mit ebener Struktur mit einer ersten halbleitenden, einkristallinen Schicht (22) aus

$$Hg_{1-x_1} Cd_{x_1} Te$$

eines ersten Leitfähigkeitstyps, wobei $x_1$ eine Zahl zwischen 0 und 1 ist, wobei diese erste Schicht einen ersten Bereich (24, 24a) eines zweiten Leitfähigkeitstyps umfaßt; einem elektrischen Isolator (30, 34), der sich oberhalb der ersten halbleitenden Schicht (22) befindet; und einem elektrischen Kontaktpunkt (38, 38a) auf dem Isolator (30, 34), der zur Aufnahme des In dem ersten Bereich (24, 24a) erzeugten elektrischen Signals dient, dadurch gekennzeichnet, daß eine zweite halbleitende, einkristalline Schicht (26) aus

$$Hg_{1-x_2} Cd_{x_2} Te$$

des ersten Leitfähigkeitstyps zwischen der ersten halbleitenden Schicht (22) und dem Isolator (30, 34) angeordnet ist, wobei $x_2$ eine Zahl größer als $x_1$ zwischen 0 und 1 ist, wobei diese zweite halbleitende Schicht (26) einen zweiten Bereich (28, 28a) des zweiten Leitfähigkeitstyps umfaßt, die sich gegenüber und in Kontakt mit dem ersten Bereich (24, 24a) befindet, und daß sich der Kontaktpunkt (38, 38a, 39) in ein Loch erstreckt, das den zweiten Bereich (28, 28a) quert und teilweise so in den ersten Bereich (24, 24a) eindringt, daß er diese Bereich kontaktiert.

2. Photovoltaischer Detektor nach Anspruch 1, dadurch gekennzeichnet, daß die erste halbleitende Schicht (22) auf einem einkristallinen Substrat aufliegt.

3. Photovoltaischer Detektor nach Anspruch 1 oder 2, dadurch gekennzeichnet, daß die erste und die zweite halbleitende Schicht (22 und 26) eine Leitfähigkeit vom Typ P und daß der erste und der zweite Bereich (24, 24a, 28, 28a) eine Leitfähigkeit vom Typ N aufweisen.

4. Photovoltaischer Detektor nach einem der Ansprüche 1 bis 3, dadurch gekennzeichnet, daß der erste Bereich (24, 24a) eine Dicke (e) zwischen 0,5 und 5 µm aufweist.

5. Photovoltaischer Detektor nach einem der Ansprüche 1 bis 4, dadurch gekennzeichnet, daß $x_1$ gleich 0,2 und $x_2$ gleich 0,4 ist.

6. Photovoltaischer Detektor nach einem der Ansprüche 1 bis 5, dadurch gekennzeichnet, daß der Leiterpunkt (38) nur teilweise die ersten und zweiten Bereiche (24a, 28a) bedeckt.

7. Photovoltaischer Detektor nach einem der Ansprüche 1 bis 6, dadurch gekennzeichnet, daß er eine integrierte Vorrichtung (45, 51) zur Verarbeitung des im ersten Bereich erzeugten Signals besitzt.

8. Verfahren zur Herstellung eines photovoltaischen Detektors mit ebener Struktur nach Anspruch 1, dadurch gekennzeichnet, daß es die folgenden Verfahrensschritte umfaßt:
   (a) Abscheiden auf einer ersten halbleitenden` einkristallinen Schicht (22) aus

$$Hg_{1-x_1} Cd_{x_1} Te$$

14

eines ersten Leitfähigkeitstyps, wobei $x_1$ eine Zahl zwischen 0 und 1 ist, einer zweiten halbleitenden, einkristallinen Schicht (26) aus

$$Hg_{1-x_2} Cd_{x_2} Te$$

eines ersten Leitfähigkeitstyps, wobei $x_2$ eine Zahl größer als $x_1$ zwischen 0 und 1 ist,

(b) Abscheiden einer ersten elektrischen Isolatorschicht (30, 34) auf die zweite Halbleiterschicht (26),

(c) Öffnen eines Fensters (32, 36) in der ersten Isolatorschicht (30, 34), um den empfindlichen Bereich (24, 28, 24a, 28a) zu bilden,

(d) Dotieren durch die erste Isolatorschicht (30, 34) der ersten und der zweiten halbleitenden Schicht (22, 26), um zwei übereinanderliegende Bereiche eines zweiten Leitfähigkeitstpys zu bilden, die den empfindlichen Bereich bilden, nämlich ein erster Bereich (24, 24a) in der ersten halbleitenden Schicht (22) und ein zweiter Bereich (28, 28a) in der zweiten halbleitenden Schicht (26),

(e) Bilden eines elektrischen Kontaktloches (41) an der Stelle des aktiven Bereichs, das die zweite halbleitende Schicht (22) teilweise durchquert,

(f) Metallisierung des elektrischen Kontaktloches (41).

9. Herstellungsverfahren nach Anspruch 8, dadurch gekennzeichnet, daß man zwischen den Schritten (d) und (e) nacheinander die Abscheidung einer zweiten Isolatorschicht (34) und das Öffnen eines Fensters (36) in dieser zweiten Isolatorschicht durchführt, um das Kontaktloch (41) herzustellen.

10. Herstellungsverfahren nach Anspruch 8, dadurch gekennzeichnet, daß man den Schritt (d) nach Schritt (e) ausführt, wobei das Fenster (36) der ersten Isolatorschicht auch dazu dient, das Kontaktloch (41) zu bilden.

11. Herstellungsverfahren nach einem der Ansprüche 8 bis 10, dadurch gekennzeichnet, daß man vor Schritt (f) eine Überdotierung mit dem zweiten Leitfähigkeitstyps am Boden (44) des Kontaktlochs (41) durchführt.

FIG. 1

FIG. 2

FIG. 3

$x_1 < x_2$

$Hg_{1-x_2} Cd_{x_2} Te$

$Hg_{1-x_1} Cd_{x_1} Te$

FIG. 4

FIG. 5

FIG. 6

FIG. 7

FIG. 8

FIG 9

FIG. 10

FIG. 11

FIG. 12

FIG. 13

FIG. 14

FIG. 15

FIG. 16

FIG. 17

FIG. 18

FIG. 19

FIG. 20